# EUROPEAN PATENT APPLICATION

(11) **EP 4 083 701 A1**
(43) Date of publication of application: **02.11.2022**
(21) Application number: 20921636.5
(22) Date of filing: 29.02.2020
(51) Int. Cl.: G02F 1/39

(54) **OPTICAL SIGNAL COPYING APPARATUS**

(71) Applicant: Huawei Technologies Co., Ltd., Shenzhen, Guangdong 518129 (CN); Aston University, Birmingham West Midlands B4 7ET (GB)
(72) Inventor: FERREIRA, Filipe, Birmingham B4 7ET (GB); GORDIENKO, Vladimir, Birmingham B4 7ET (GB); TAN, Sisi, Shenzhen, Guangdong 518129 (CN); DORAN, Nick, Birmingham B4 7ET (GB)
(74) Representative: Thun, Clemens
(86) International application number: PCT/CN2020/077363
(87) International publication number: WO 2021/168868

(57) **Abstract**

Embodiments of this application disclose an optical signal copier and an optical parametric amplifier, which are applied to the communications field. In the embodiments of this application, the optical signal copier included in the optical parametric amplifier generates an invalid signal in a process of transmitting signal light and pump light. The optical signal copier may separate the signal light from the invalid signal and then transmit the signal light to a signal processing module. In this way, the signal processing module may directly process the signal light that does not include the invalid signal, the invalid signal does not occupy transmission bandwidth of the optical parametric amplifier, and effective transmission bandwidth of the optical parametric amplifier is relatively large.

## Description

### TECHNICAL FIELD

Embodiments of this application relate to the field of wireless communications, and in particular, to an optical signal copier.

### BACKGROUND

An optical parametric amplifier (optical amplifier) is an amplifier that can amplify an optical signal in an optical fiber communications system. The optical parametric amplifier is a device that may directly amplify an optical signal without converting the optical signal into an electrical signal. A principle of the optical parametric amplifier is to implement an amplification function by converting energy of pump light into energy of signal light based on stimulated radiation of laser light.

An optical signal copier (copier) is an apparatus for preprocessing an optical signal in the optical parametric amplifier. A pump laser transmits pump light to the optical signal copier, and a transmitter transmits signal light to the optical signal copier. In this way, the optical signal copier may transmit the pump light and the signal light to a signal processing module included in the optical parametric amplifier. However, the pump light and the signal light generate an invalid signal in a transmission process of the optical signal copier, and the optical signal copier transmits the pump light, the signal light, and the invalid signal to the signal processing module.

The optical signal copier sends the pump light, the signal light, and the invalid signal to the signal processing module, the invalid signal occupies transmission bandwidth of the optical parametric amplifier, and effective transmission bandwidth of the optical parametric amplifier is small.

### SUMMARY

Embodiments of this application provide an optical signal copier and an optical parametric amplifier. The optical signal copier may separate signal light from an invalid signal and then transmit the signal light to a signal processing module, to increase effective transmission bandwidth of the optical parametric amplifier.

A first aspect of this application provides an optical signal copier. The optical signal copier includes a first coupler, a second coupler, a first nonlinear medium, a second nonlinear medium, and a first phase shifter. A first end of the first coupler is connected to a pump laser, a second end of the first coupler is connected to a transmitter, a third end of the first coupler is connected to a first end of the first nonlinear medium, and a fourth end of the first coupler is connected to a first end of the first phase shifter. A second end of the first nonlinear medium is connected to a first end of the second coupler. A second end of the first phase shifter is connected to a first end of the second nonlinear medium. A second end of the second nonlinear medium is connected to a second end of the second coupler. First pump light emitted by the pump laser is input to the first end of the first coupler, the second end of the first coupler receives first signal light emitted by the transmitter, and after the first coupler couples the first pump light and the first signal light based on a first proportion, the third end of the first coupler outputs second pump light and second signal light to the first nonlinear medium, and the fourth end of the first coupler outputs third pump light and third signal light to the first phase shifter. After the first nonlinear medium receives the second pump light and the second signal light, a three-wave mixing effect or a four-wave mixing effect occurs on the second pump light and the second signal light in the first nonlinear medium, and a first invalid signal is generated after the three-wave mixing effect or the four-wave mixing effect occurs on the second pump light and the second signal light. After the first phase shifter receives the third pump light and the third signal light, fourth pump light is generated after the first phase shifter adds a first phase shift to the third pump light. After the second nonlinear medium receives the fourth pump light and the third signal light, a three-wave mixing effect or a four-wave mixing effect occurs on the fourth pump light and the third signal light in the second nonlinear medium, and a second invalid signal is generated after the three-wave mixing effect or the four-wave mixing effect occurs on the fourth pump light and the third signal light. The second pump light, the second signal light, and the first invalid signal that are output by the first nonlinear medium are input at the first end of the second coupler, the fourth pump light, the third signal light, and the second invalid signal are input at the second end of the second coupler, and the second coupler couples, based on a second proportion, optical signals that are input at the first end and the second end of the second coupler. After the second coupler couples, based on the proportion, the optical signals that are input at the first end and the second end of the second coupler, the first invalid signal and the second invalid signal cancel each other after interference occurs on the first invalid signal and the second invalid signal at a third end of the second coupler, constructive interference occurs on the second signal light and the third signal light at the third end of the second coupler, and the third end of the second coupler outputs signal light generated after the constructive interference.

In this embodiment of this application, the optical signal copier included in an optical parametric amplifier generates an invalid signal in a process of transmitting signal light and pump light. The optical signal copier may separate the signal light from the invalid signal and then transmit the signal light to a signal processing module. In this way, the signal processing module may directly process the signal light that does not include the invalid signal, the invalid signal does not occupy transmission bandwidth of the optical parametric amplifier, and effective transmission bandwidth of the optical parametric amplifier is relatively large.

In a possible implementation of the first aspect, for the optical signal copier, the first phase shift is 2πi, i is a positive integer greater than zero, the first invalid signal is a first crosstalk signal, and the second invalid signal is a second crosstalk signal.

In this possible implementation, after the second pump light and the second signal light are input to the first nonlinear medium, the three-wave mixing effect or the four-wave mixing effect occurs on the second pump light and the second signal light in the first nonlinear medium, and the first crosstalk signal is generated after the three-wave mixing effect or the four-wave mixing effect occurs on the second pump light and the second signal light. After the third pump light and the third signal light are input to the first phase shifter, the fourth pump light is generated after the first phase shifter adds 2πi to a phase of the third pump light. After the fourth pump light and the third signal light are input to the second nonlinear medium, the three-wave mixing effect or the four-wave mixing effect occurs on the fourth pump light and the third signal light in the second nonlinear medium, and the second crosstalk signal is generated after the three-wave mixing effect or the four-wave mixing effect occurs on the fourth pump light and the third signal light. After the second coupler couples, based on the proportion, the optical signals that are input at the first end and the second end of the second coupler, the first crosstalk signal and the second crosstalk signal cancel each other after interference occurs on the first crosstalk signal and the second crosstalk signal at the third end of the second coupler, constructive interference occurs on the second signal light and the third signal light at the third end of the second coupler, and the third end of the second coupler outputs the signal light generated after the constructive interference. In this possible implementation, the optical signal copier implements separation between signal light and a crosstalk signal. In this way, the signal processing module may directly process the signal light that does not include the crosstalk signal, the crosstalk signal does not occupy transmission bandwidth of the optical parametric amplifier, and effective transmission bandwidth of the optical parametric amplifier is relatively large.

In a possible implementation of the first aspect, for the optical signal copier, the first phase shift is π/2 + πi, i is a positive integer greater than zero, the first invalid signal is first idler light, and the second invalid signal is second idler light.

In this possible implementation, after the second pump light and the second signal light are input to the first nonlinear medium, the three-wave mixing effect or the four-wave mixing effect occurs on the second pump light and the second signal light in the first nonlinear medium, and the first idler light is generated after the three-wave mixing effect or the four-wave mixing effect occurs on the second pump light and the second signal light. After the third pump light and the third signal light are input to the first phase shifter, the fourth pump light is generated after the first phase shifter adds π/2 + πi to a phase of the third pump light. After the fourth pump light and the third signal light are input to the second nonlinear medium, the three-wave mixing effect or the four-wave mixing effect occurs on the fourth pump light and the third signal light in the second nonlinear medium, and the second idler light is generated after the three-wave mixing effect or the four-wave mixing effect occurs on the fourth pump light and the third signal light. After the second coupler couples, based on the proportion, the optical signals that are input at the first end and the second end of the second coupler, the first idler light and the second idler light cancel each other after interference occurs on the first idler light and the second idler light at the third end of the second coupler, constructive interference occurs on the second signal light and the third signal light at the third end of the second coupler, and the third end of the second coupler outputs the signal light generated after the constructive interference. The optical signal copier implements separation between signal light and idler light. In this way, the signal processing module may directly process the signal light that does not include the idler light, the idler light does not occupy transmission bandwidth of the optical parametric amplifier, and effective transmission bandwidth of the optical parametric amplifier is relatively large.

In a possible implementation of the first aspect, for the optical signal copier, the optical signal copier further includes a second phase shifter. A first end of the second phase shifter is connected to the second nonlinear medium. A second end of the second phase shifter is connected to the second end of the second coupler. After the fourth pump light, the third signal light, and the second invalid signal are input to the second phase shifter, fifth pump light is generated after the second phase shifter adds a second phase shift to a phase of the fourth pump light, and the second end of the second phase shifter transmits the fifth pump light to the second end of the second coupler.

In this possible implementation, the optical signal copier includes the second phase shifter, and an operator may control an output position of pump light in the optical signal copier by changing the second phase shift of the second phase shifter. This possible implementation improves accuracy of the optical signal copier.

In a possible implementation of the first aspect, for the optical signal copier, the first proportion is 1:1. After the first coupler couples the first pump light and the first signal light based on the proportion 1:1, the third end of the first coupler outputs the second pump light and the second signal light to the first nonlinear medium. Signal strength of the second pump light is 50% of signal strength of the first pump light, and a phase difference between the second pump light and the first pump light is π/2. Signal strength of the second signal light is 50% of signal strength of the first signal light, and phases of the second signal light and the first signal light are the same. The fourth end of the first coupler outputs the third pump light and the third signal light to the second nonlinear medium. Signal strength of the third pump light is 50% of the signal strength of the first pump light, and phases of the third pump light and the first pump light are the same. Signal strength of the third signal light is 50% of the signal strength of the first signal light, and a phase difference between the third signal light and the first signal light is π/2.

In this possible implementation, a coupling proportion of the first coupler included in the optical signal copier is 1:1. This possible implementation improves feasibility of the solution.

In a possible implementation of the first aspect, for the optical signal copier, the optical signal copier further includes a second phase shifter. A first end of the second phase shifter is connected to the second nonlinear medium. A second end of the second phase shifter is connected to the second end of the second coupler. After the second phase shifter receives the fourth pump light, the third signal light, and the second invalid signal, fifth pump light is generated after the second phase shifter adds a second phase shift to a phase of the fourth pump light, and the second end of the second phase shifter transmits the fifth pump light to the second end of the second coupler.

In this possible implementation, when the second phase shift is 2πi, pump light is to be output from a fourth end of the second coupler of the optical signal copier. In this way, separation between signal light and the pump light may be implemented. This possible implementation improves accuracy of the optical signal copier.

In a possible implementation of the first aspect, for the optical signal copier, the second phase shift is π + 2πi, and i is a positive integer greater than zero. The first end of the second coupler receives the third pump light, and the second end of the second coupler receives the fifth pump light. The third pump light and the fifth pump light cancel each other after interference occurs on the third pump light and the fifth pump light at the fourth end of the second coupler. Constructive interference occurs on the third pump light and the fifth pump light at the third end of the second coupler, and the third end of the second coupler outputs pump light generated after the constructive interference.

In this possible implementation, when the second phase shift is π + 2πi, the pump light is to be output from the third end of the second coupler of the optical signal copier. This possible implementation improves feasibility of the solution.

A second aspect of this application provides an optical signal copier. The optical signal copier includes a first circulator, a second circulator, a third coupler, a third phase shifter, and a third nonlinear medium. A first end of the first circulator is connected to a transmitter, a second end of the first circulator is connected to a first end of the third coupler, and a third end of the first circulator is connected to a third attenuator. A first end of the second circulator is connected to a pump laser, a second end of the second circulator is connected to a second end of the third coupler, and a third end of the second circulator is connected to a fourth attenuator. A third end of the third coupler is connected to a first end of the third phase shifter, and a fourth end of the third coupler is connected to a first end of the third nonlinear medium. A second end of the third phase shifter is connected to a second end of the nonlinear medium. After the first end of the first circulator receives fourth signal light emitted by the transmitter, the second end of the first circulator outputs the fourth signal light to the first end of the third coupler. After the first end of the second circulator receives sixth pump light emitted by the pump laser, the second end of the second circulator outputs the sixth pump light to the second end of the third coupler. The first end of the third coupler receives the fourth signal light that is output from the second end of the first circulator, and the second end of the third coupler receives the sixth pump light emitted by the second end of the second circulator. After the third coupler couples the fourth signal light and the sixth pump light based on a proportion, the third end of the third coupler outputs fifth signal light and seventh pump light to the first end of the third phase shifter, and the fourth end of the third coupler outputs sixth signal light and eighth pump light to the first end of the third nonlinear medium. When optical signals are transmitted counterclockwise in the optical signal copier, after the first end of the third phase shifter receives the fifth signal light and the seventh pump light, ninth pump light is generated after the third phase shifter adds a third phase shift to the seventh pump light, and the second end of the third phase shifter outputs the fifth signal light and the ninth pump light to the third nonlinear medium. After the second end of the third nonlinear medium receives the fifth signal light and the ninth pump light, a three-wave mixing effect or a four-wave mixing effect occurs on the fifth signal light and the ninth pump light in the third nonlinear medium, and a third invalid signal is generated after the three-wave mixing effect or the four-wave mixing effect occurs on the fifth signal light and the ninth pump light. The first end of the third nonlinear medium inputs the fifth signal light, the ninth pump light, and the third invalid signal to the fourth end of the third coupler. When optical signals are transmitted clockwise in the optical signal copier, after the first end of the third nonlinear medium receives the sixth signal light and the eighth pump light, a three-wave mixing effect or a four-wave mixing effect occurs on the sixth signal light and the eighth pump light in the third nonlinear medium, and a fourth invalid signal is generated after the three-wave mixing effect or the four-wave mixing effect occurs on the sixth signal light and the eighth pump light. The second end of the third nonlinear medium inputs the sixth signal light, the eighth pump light, and the fourth invalid signal to the second end of the third phase shifter. The second end of the third phase shifter receives the sixth signal light, the eighth pump light, and the fourth invalid signal, and tenth pump light is generated after the third phase shifter adds a fourth phase shift to the eighth pump light. The first end of the third phase shifter inputs the sixth signal light, the tenth pump light, and the fourth invalid signal to the third end of the third coupler. After the third coupler couples, based on a proportion, optical signals that are received at the third end and the fourth end, the third invalid signal and the fourth invalid signal cancel each other after interference occurs on the third invalid signal and the fourth invalid signal at the first end of the third coupler, constructive interference occurs on the fifth signal light and the sixth signal light, and the first end of the third coupler outputs signal light generated after the constructive interference to the second end of the first circulator. The second end of the third coupler outputs pump light generated after constructive interference and an invalid signal generated after constructive interference. After the second end of the first circulator receives the signal light generated after the constructive interference, the third end of the first circulator outputs the signal light generated after the constructive interference to the third attenuator.

In this embodiment of this application, the optical signal copier included in an optical parametric amplifier generates an invalid signal in a process of transmitting signal light and pump light. The optical signal copier may separate the signal light from the invalid signal and then transmit the signal light to a signal processing module. In this way, the signal processing module may directly process the signal light that does not include the invalid signal, the invalid signal does not occupy transmission bandwidth of the optical parametric amplifier, and effective transmission bandwidth of the optical parametric amplifier is relatively large.

In a possible implementation of the second aspect, for the optical signal copier, the third phase shift is 2πi, i is a positive integer greater than zero, the third invalid signal is a third crosstalk signal, and the fourth invalid signal is a fourth crosstalk signal.

In this possible implementation, when the third phase shift is 2πi, the optical signal copier implements separation between signal light and a crosstalk signal. In this way, the signal processing module may directly process the signal light that does not include the crosstalk signal, the crosstalk signal does not occupy transmission bandwidth of the optical parametric amplifier, and effective transmission bandwidth of the optical parametric amplifier is relatively large.

In a possible implementation of the second aspect, for the optical signal copier, the third phase shift is π/2 + 2πi, i is a positive integer greater than zero, the third invalid signal is third idler light, and the fourth invalid signal is fourth idler light.

In this possible implementation, when the third phase shift is π/2 + 2πi, the optical signal copier implements separation between signal light and idler light. In this way, the signal processing module may directly process the signal light that does not include the idler light, the idler light does not occupy transmission bandwidth of the optical parametric amplifier, and effective transmission bandwidth of the optical parametric amplifier is relatively large.

In a possible implementation of the second aspect, for the optical signal copier, the third proportion is 1:1. After the third coupler couples the fourth signal light and the sixth pump light based on the proportion 1:1, the third end of the third coupler outputs the fifth signal light and the seventh pump light to the first end of the third phase shifter. Signal strength of the fifth signal light is 50% of signal strength of the fourth signal light, and phases of the fifth signal light and the fourth signal light are the same. Signal strength of the seventh pump light is 50% of signal strength of the sixth pump light, and a phase difference between the seventh pump light and the sixth pump light is π/2. The fourth end of the third coupler outputs the sixth signal light and the eighth pump light to the first end of the third nonlinear medium. Signal strength of the sixth signal light is 50% of the signal strength of the fourth signal light, and a phase difference between the sixth signal light and the fourth signal light is π/2. Signal strength of the eighth pump light is 50% of the signal strength of the sixth pump light, and phases of the eighth pump light and the sixth pump light are the same.

In this possible implementation, a coupling proportion of the third coupler included in the optical signal copier is 1:1. This possible implementation improves feasibility of the solution. A third aspect of this application provides an optical parametric amplifier. The optical parametric amplifier includes an optical signal copier, a signal processing apparatus, and a signal amplification apparatus. The signal processing apparatus is configured to process an optical signal that is output by the optical signal copier, and the signal processing apparatus includes a first attenuator and a second attenuator. The signal amplification apparatus is configured to amplify an optical signal processed by the signal processing apparatus. The optical signal copier is the optical signal copier described in any one of the first aspect or the possible implementations of the first aspect.

A fourth aspect of this application provides an optical parametric amplifier. The optical parametric amplifier includes an optical signal copier, a signal processing apparatus, and a signal amplification apparatus. The signal processing apparatus is configured to process an optical signal that is output by the optical signal copier, and the signal processing apparatus includes a first attenuator and a second attenuator. The signal amplification apparatus is configured to amplify an optical signal processed by the signal processing apparatus. The optical signal copier is the optical signal copier described in any one of the second aspect or the possible implementations of the second aspect.

It can be learned from the foregoing technical solutions that the embodiments of this application have the following advantages:

In the embodiments of this application, the optical signal copier included in the optical parametric amplifier generates an invalid signal in a process of transmitting signal light and pump light. The optical signal copier may separate the signal light from the invalid signal and then transmit the signal light to the signal processing module. In this way, the signal processing module may directly process the signal light that does not include the invalid signal, the invalid signal does not occupy transmission bandwidth of the optical parametric amplifier, and effective transmission bandwidth of the optical parametric amplifier is relatively large.

### BRIEF DESCRIPTION OF DRAWINGS

FIG. 1 is a schematic structural diagram of an optical parametric amplifier according to an embodiment of this application;
FIG. 2 is a schematic diagram of an embodiment of an optical signal copier according to an embodiment of this application;
FIG. 3 is a schematic diagram of another embodiment of an optical signal copier according to an embodiment of this application;
FIG. 4 is a schematic diagram of another embodiment of an optical signal copier according to an embodiment of this application; and
FIG. 5 is a schematic diagram of another embodiment of an optical signal copier according to an embodiment of this application.

### DESCRIPTION OF EMBODIMENTS

The following describes embodiments of this application with reference to the accompanying drawings. It is clear that the described embodiments are merely some rather than all of the embodiments of this application. A person of ordinary skill in the art may learn that the technical solutions provided in the embodiments of this application are also applicable to a similar technical problem as a technology evolves and a new scenario emerges.

In the specification, claims, and accompanying drawings of this application, the terms "first", "second", and the like are intended to distinguish between similar objects but do not indicate a specific order or sequence. It should be understood that the data used in such a way are interchangeable in proper circumstances so that the embodiments described herein can be implemented in other orders than the order illustrated or described herein. Moreover, the terms "include", "have" and any other variants mean to cover the non-exclusive inclusion, for example, a process, method, system, product, or device that includes a list of steps or units is not necessarily limited to those steps or units, but may include other steps or units not expressly listed or inherent to such a process, method, system, product, or device.

An optical signal copier is connected to a signal transmit apparatus. The signal transmit apparatus is an apparatus for providing an optical signal for an optical parametric amplifier, and the signal transmit apparatus includes a pump laser and a transmitter. The pump laser transmits pump light to the optical signal copier, and the transmitter transmits signal light to the optical signal copier. In this way, the optical signal copier may transmit the pump light and the signal light to a signal processing apparatus included in the optical parametric amplifier, and the signal processing apparatus is a signal processing module in the optical parametric amplifier. However, the pump light and the signal light generate an invalid signal in a transmission process of the optical signal copier, and the optical signal copier transmits the pump light, the signal light, and the invalid signal to the signal processing apparatus.

The optical signal copier sends the pump light, the signal light, and the invalid signal to the signal processing apparatus. The invalid signal occupies transmission bandwidth of the signal processing apparatus, and then the invalid signal occupies transmission bandwidth of a signal amplification apparatus. From a perspective of the optical parametric amplifier as a whole, in this way, the invalid signal occupies transmission bandwidth of the optical parametric amplifier, and effective transmission bandwidth of the optical parametric amplifier is small.

In view of the foregoing problem of an existing optical parametric amplifier, embodiments of this application provide an optical signal copier and a related optical parametric amplifier, to increase effective transmission bandwidth of the optical parametric amplifier.

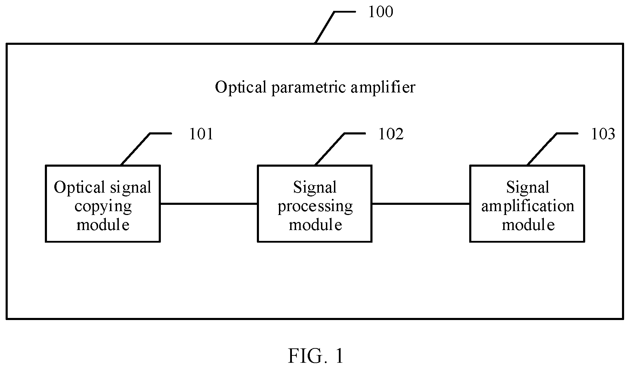

FIG. 1 is a schematic structural diagram of an optical parametric amplifier according to an embodiment of this application.

Referring to FIG. 1, as shown in FIG. 1, an optical parametric amplifier 100 provided in this embodiment of this application includes an optical signal copying module 101, a signal processing module 102, and a signal amplification module 103.

The optical signal copying module 101 is connected to the signal processing module 102, and the signal processing module 102 is connected to the signal amplification module 103.

The optical signal copying module is a module for processing an optical signal in the optical parametric amplifier, that is, an optical signal copier. The optical signal copier is a previous-stage structure of a signal amplification apparatus. The optical signal copier generally includes one stage of phase insensitive amplifier (phase insensitive amplifier, PIA), and a main function of the optical signal copier is to generate an optical signal that meets requirements of the signal processing module and the signal amplification module.

In this embodiment of this application, it may be understood that the optical signal copying module mentioned in this embodiment of this application may be applied to any scenario in which signal processing needs to be performed, and specifically, may be applied to the optical parametric amplifier. The optical parametric amplifier may be a phase sensitive amplifier (phase sensitive amplifier, PSA).

The signal processing module is a module for processing an optical signal in the optical parametric amplifier. After receiving an optical signal sent by the optical signal copying module, the signal processing module may process the received optical signal. Optionally, a signal processing manner includes power equilibrium, phase control, polarization control, and another signal processing manner. This is not specifically limited herein.

The signal amplification module is configured to amplify an optical signal.

The optical signal copier provided in the embodiments of this application is to be described based on the schematic structural diagram of the optical parametric amplifier described in FIG. 1.

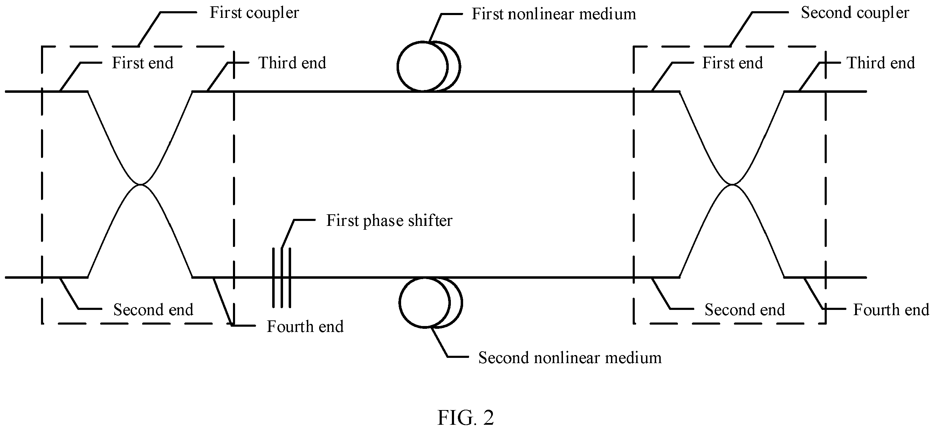

FIG. 2 is a schematic diagram of an embodiment of an optical signal copier according to an embodiment of this application.

Referring to FIG. 2, as shown in FIG. 2, the optical signal copier mentioned in this embodiment of this application includes a first coupler, a second coupler, a first nonlinear medium, a second nonlinear medium, and a first phase shifter.

The nonlinear medium mentioned in this embodiment of this application has a large nonlinear coefficient and small dispersion. Optionally, the nonlinear medium provided in this embodiment of this application may be a highly nonlinear fiber (highly nonlinear fiber, HNLF), may be a photonic crystal fiber (photonic crystal fiber, PCF), or may be another type of nonlinear medium such as a periodically poled lithium niobate (periodically poled lithium niobate, PPLN) waveguide. This is not specifically limited herein.

The phase shifter mentioned in this embodiment of this application refers to an element configured to change a phase of a transmitted wave in a microwave circuit. Optionally, the phase shifter mentioned in this embodiment of this application may be a fiber Bragg grating (fiber Bragg grating, FBG), may be an electro-optic modulator, or may be another type of phase shifter such as an acousto-optic modulator. This is not specifically limited herein.

In this embodiment of this application, a first end of the first coupler is connected to a pump laser, a second end of the first coupler is connected to a transmitter, a third end of the first coupler is connected to a first end of the first nonlinear medium, and a fourth end of the first coupler is connected to a first end of the first phase shifter.

The coupler mentioned in this embodiment of this application is a fiber coupler. The fiber coupler is also referred to as a splitter, a connector, and an adapter, and is an element configured to implement optical signal splitting or combination. The fiber coupler is applied to various transmission networks, such as a telecommunications network, a cable television network, and an area network.

A second end of the first nonlinear medium is connected to a first end of the second coupler.

A second end of the first phase shifter is connected to a first end of the second nonlinear medium.

A second end of the second nonlinear medium is connected to a second end of the second coupler.

A third end of the second coupler is connected to a first attenuator, and a fourth end of the second coupler is connected to a second attenuator.

In this embodiment of this application, the optical signal copier in an optical parametric amplifier is connected to a signal processing module. Optionally, the signal processing module includes the first attenuator and the second attenuator, and the signal processing module may further include another component. This is not specifically limited herein.

In this embodiment of this application, the first end of the first coupler receives first pump light emitted by the pump laser, and the second end of the first coupler receives first signal light emitted by the transmitter. After the first coupler couples the first pump light and the first signal light based on a proportion, the third end of the first coupler outputs second pump light and second signal light to the first nonlinear medium, and the fourth end of the first coupler outputs third pump light and third signal light to the first phase shifter.

In this embodiment of this application, the first coupler couples the first pump light and the first signal light based on a specific proportion. A specific coupling proportion may be 1:1.

After a third coupler couples fourth signal light and sixth pump light based on the proportion 1:1, a third end of the third coupler outputs fifth signal light and seventh pump light to a first end of a third phase shifter. Signal strength of the fifth signal light is 50% of signal strength of the fourth signal light, and phases of the fifth signal light and the fourth signal light are the same. Signal strength of the seventh pump light is 50% of signal strength of the sixth pump light, and a phase difference between the seventh pump light and the sixth pump light is π/2.

A fourth end of the third coupler outputs sixth signal light and eighth pump light to a first end of a third nonlinear medium. Signal strength of the sixth signal light is 50% of the signal strength of the fourth signal light, and a phase difference between the sixth signal light and the fourth signal light is π/2. Signal strength of the eighth pump light is 50% of the signal strength of the sixth pump light, and phases of the eighth pump light and the sixth pump light are the same.

In this embodiment of this application, the optical signal copier is connected to a transmit apparatus, and the transmit apparatus is an apparatus for generating an optical signal. Optionally, the transmit apparatus may include a pump laser and a transmitter, and the transmit apparatus may further include another component related to an optical signal. This is not specifically limited herein.

After the first nonlinear medium receives the second pump light and the second signal light, a three-wave mixing effect or a four-wave mixing effect occurs on the second pump light and the second signal light in the first nonlinear medium, and a first invalid signal is generated after the three-wave mixing effect or the four-wave mixing effect occurs on the second pump light and the second signal light.

In this embodiment of this application, optionally, the first invalid signal may be a crosstalk signal, or the first invalid signal may be idler light. This is not specifically limited herein.

In this embodiment of this application, optionally, the three-wave mixing effect or the four-wave mixing effect may occur on the second pump light and the second signal light in the first nonlinear medium. A specific type of effect is determined by a type of the nonlinear medium.

After the first phase shifter receives the third pump light and the third signal light, fourth pump light is generated after the first phase shifter adds a first phase shift to the third pump light.

After the second nonlinear medium receives the fourth pump light and the third signal light, a three-wave mixing effect or a four-wave mixing effect occurs on the fourth pump light and the third signal light in the second nonlinear medium, and a second invalid signal is generated after the three-wave mixing effect or the four-wave mixing effect occurs on the fourth pump light and the third signal light.

In this embodiment of this application, optionally, the second invalid signal may be a crosstalk signal, or the second invalid signal may be idler light. This is not specifically limited herein.

In this embodiment of this application, optionally, the three-wave mixing effect or the four-wave mixing effect may occur on the fourth pump light and the third signal light in the second nonlinear medium. A specific type of effect is determined by a type of the nonlinear medium.

The second pump light, the second signal light, and the first invalid signal are input at the first end of the second coupler, the fourth pump light, the third signal light, and the second invalid signal are input at the second end of the second coupler, and the second coupler couples, based on a proportion, transmitted signals that are input at the first end and the second end of the second coupler.

In this embodiment of this application, the second coupler couples, based on a specific proportion, optical signals that are input at the first end and the second end of the second coupler. A specific coupling proportion may be 1:1.

After the second coupler couples, based on the proportion, the transmitted signals that are input at the first end and the second end of the second coupler, the first invalid signal and the second invalid signal cancel each other after interference occurs on the first invalid signal and the second invalid signal at a third end of the second coupler, constructive interference occurs on the second signal light and the third signal light at the third end of the second coupler, and the third end of the second coupler outputs signal light generated after the constructive interference.

In this embodiment of this application, optionally, when the first phase shift is 2πi, i is a positive integer greater than zero. After the first nonlinear medium receives the second pump light and the second signal light, a three-wave mixing effect or a four-wave mixing effect occurs on the second pump light and the second signal light in the first nonlinear medium, and a first crosstalk signal is generated after the three-wave mixing effect or the four-wave mixing effect occurs on the second pump light and the second signal light.

After the first phase shifter receives the third pump light and the third signal light, the fourth pump light is generated after the first phase shifter adds 2πi to a phase of the third pump light.

After the second nonlinear medium receives the fourth pump light and the third signal light, a three-wave mixing effect or a four-wave mixing effect occurs on the fourth pump light and the third signal light in the second nonlinear medium, and a second crosstalk signal is generated after the three-wave mixing effect or the four-wave mixing effect occurs on the fourth pump light and the third signal light.

The first invalid signal is the first crosstalk signal, and the second invalid signal is the second crosstalk signal. The first crosstalk signal and the second crosstalk signal cancel each other after interference occurs on the first crosstalk signal and the second crosstalk signal at the third end of the first coupler, so that separation between signal light and a crosstalk signal is implemented in a signal output by the copier.

In this embodiment of this application, optionally, when the first phase shift is π/2 + πi, i is a positive integer greater than zero. The first invalid signal is first idler light, and the second invalid signal is second idler light. The first idler light and the second idler light cancel each other after interference occurs on the first idler light and the second idler light at the third end of the first coupler, so that separation between signal light and idler light is implemented in a signal output by the optical signal copier.

In this embodiment of this application, the optical signal copier included in the optical parametric amplifier generates an invalid signal in a process of transmitting signal light and pump light. The optical signal copier may separate the signal light from the invalid signal and then transmit the signal light to the signal processing module. In this way, the signal processing module may directly process the signal light that does not include the invalid signal, the invalid signal does not occupy transmission bandwidth of the optical parametric amplifier, and effective transmission bandwidth of the optical parametric amplifier is relatively large.

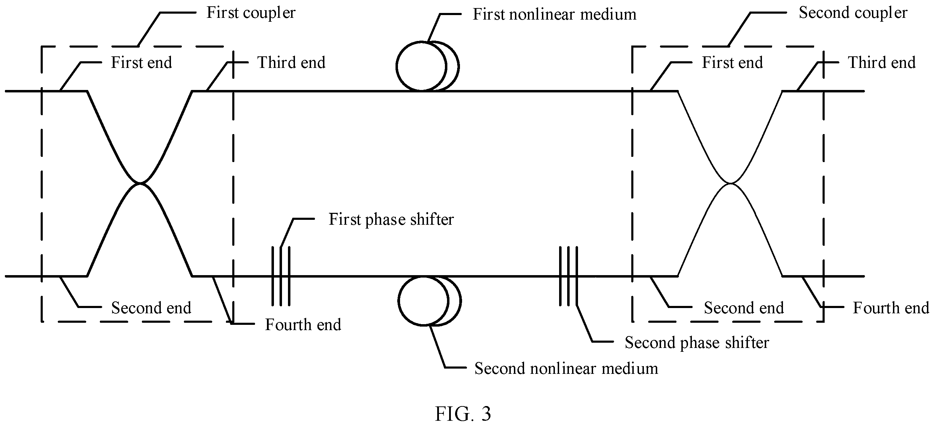

FIG. 3 is a schematic diagram of an embodiment of an optical signal copier according to an embodiment of this application.

Referring to FIG. 3, based on the optical signal copier shown in FIG. 2 and described in the foregoing embodiment, the optical signal copier provided in this embodiment may further include a second phase shifter.

A first end of the second phase shifter is connected to the second nonlinear medium.

A second end of the second phase shifter is connected to the second end of the second coupler.

After the second phase shifter receives the fourth pump light, the third signal light, and the second invalid signal, fifth pump light is generated after the second phase shifter adds a second phase shift to a phase of the fourth pump light. The second end of the second phase shifter transmits the fifth pump light to the second end of the second coupler.

In this embodiment of this application, when the second phase shift is 2πi, i is a positive integer greater than zero. The first end of the second coupler receives the third pump light, and the second end of the second coupler receives the fifth pump light. The third pump light and the fifth pump light cancel each other after interference occurs on the third pump light and the fifth pump light at the third end of the second coupler. Constructive interference occurs on the third pump light and the fifth pump light at the fourth end of the second coupler, and the fourth end of the second coupler outputs pump light generated after the constructive interference. The third end of the second coupler outputs the signal light, and the fourth end of the second coupler outputs the pump light, so that separation between the pump light and the signal light may be implemented.

In this embodiment of this application, when the second phase shift is π + 2πi, i is a positive integer greater than zero. The first end of the second coupler receives the third pump light, and the second end of the second coupler receives the fifth pump light. The third pump light and the fifth pump light cancel each other after interference occurs on the third pump light and the fifth pump light at the fourth end of the second coupler. Constructive interference occurs on the third pump light and the fifth pump light at the third end of the second coupler, and the third end of the second coupler outputs pump light generated after the constructive interference. In this embodiment of this application, the second phase shift applied by the second phase shifter to the pump light may be controlled, to control the pump light to be output from the third end of the second coupler together with the signal light.

In this embodiment of this application, the optical signal copier included in the optical parametric amplifier generates an invalid signal in a process of transmitting signal light and pump light. The optical signal copier may separate the signal light from the invalid signal and then transmit the signal light to the signal processing module. In this way, the signal processing module may directly process the signal light that does not include the invalid signal, the invalid signal does not occupy transmission bandwidth of the optical parametric amplifier, and effective transmission bandwidth of the optical parametric amplifier is relatively large.

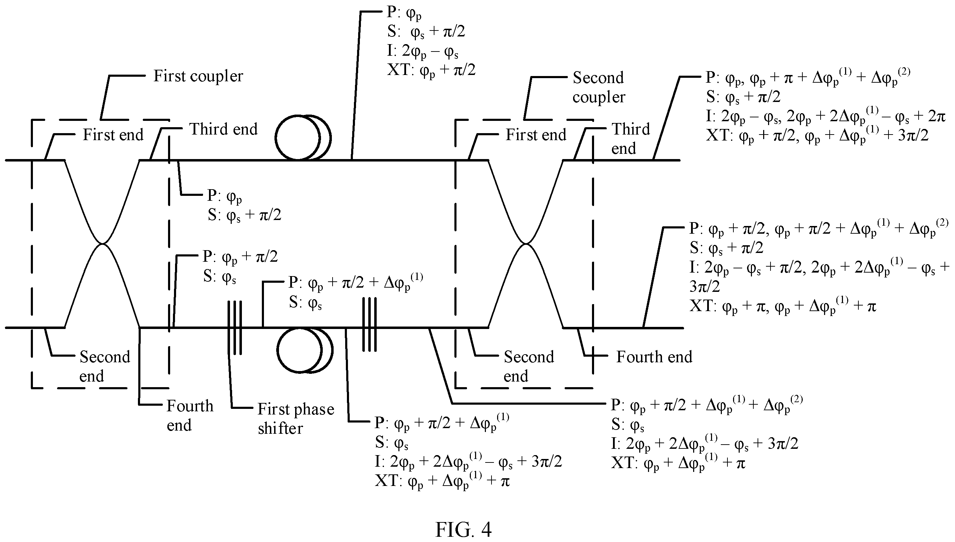

FIG. 4 is a schematic diagram of an embodiment of an optical signal copier according to an embodiment of this application.

Referring to FIG. 4, an optical signal transmission process in the optical signal copier is described in detail in the following embodiment.

For example, in this embodiment of this application, as shown in FIG. 4, P is a phase of pump light, S is a phase of signal light, I is a phase of idler light, and XT is a phase of a crosstalk signal.

A phase of first pump light that is input at a first end of a first coupler is ϕₚ, and a phase of first signal light that is input at a second end of the first coupler is ϕₛ. After coupling by the first coupler, a phase of second pump light that is output by a third end of the first coupler is ϕₚ, a phase of second signal light that is output by the third end of the first coupler is ϕₛ + π/2, a phase of third pump light that is output by a fourth end of the first coupler is ϕₚ + π/2, and a phase of third signal light that is output by the fourth end of the first coupler is ϕₛ.

Fourth pump light is generated after a first phase shifter adds a first phase shift Δϕₚ⁽¹⁾ to the third pump light, and a phase of the fourth pump light is ϕₚ + π/2 + Δϕₚ⁽¹⁾.

The second pump light and the second signal light are input to a first nonlinear medium, and idler light and a crosstalk signal are generated after a three-wave mixing effect or a four-wave mixing effect occurs in the first nonlinear medium. Based on a formula of generating idler light in a nonlinear medium, it may be learned that a phase of first idler light is 2ϕₚ - ϕₛ. Based on a formula of generating a crosstalk signal in a nonlinear medium, it may be learned that a phase of a first crosstalk signal is ϕₚ + π/2.

The fourth pump light and the third signal light are input to a second nonlinear medium, and idler light and a crosstalk signal are generated after a three-wave mixing effect or a four-wave mixing effect occurs in the second nonlinear medium. Based on the formula of generating idler light in a nonlinear medium, it may be learned that a phase of second idler light is 2ϕₚ + 2Δϕₚ⁽¹⁾ - ϕₛ + 3π/2. Based on the formula of generating a crosstalk signal in a nonlinear medium, it may be learned that a phase of a second crosstalk signal is ϕₚ + Δϕₚ⁽¹⁾ + π.

After the fourth pump light, the third signal light, the second idler light, and the second crosstalk signal are input to a second phase shifter, the second phase shifter adds a second phase shift Δϕₚ⁽²⁾ to the fourth pump light, to generate fifth pump light. A phase of the fifth pump light is ϕₚ + π/2 + Δϕₚ⁽¹⁾ + Δϕₚ⁽²⁾.

The second pump light, the second idler light, and a first invalid signal are input to a first end of a second coupler, and the fourth pump light, the third signal light, and a second invalid signal are input to a second end of the second coupler. After the second coupler couples optical signals that are input at the first end of the second coupler and the second end of the second coupler, signal light that is output at a third end of the second coupler has two phases, which are respectively ϕₚ and ϕₚ + π + Δϕₚ⁽¹⁾ + Δϕₚ⁽²⁾. Pump light that is output at the third end of the second coupler has two phases, which are respectively ϕₛ + π/2 and ϕₛ + π/2. Idler light that is output at the third end of the second coupler has two phases, which are respectively 2ϕₚ - ϕₛ and 2ϕₚ + 2Δϕₚ⁽¹⁾ - ϕₛ + 2π. A crosstalk signal that is output at the third end of the second coupler has two phases, which are respectively ϕₚ + π/2 and ϕₚ + Δϕₚ⁽¹⁾ + 3π/2.

Signal light that is output at a fourth end of the second coupler has two phases, which are respectively ϕₚ + π/2 and ϕₚ + π/2 + Δϕₚ⁽¹⁾ + Δϕₚ⁽²⁾. Pump light that is output at the fourth end of the second coupler has two phases, which are respectively ϕₛ + π/2 and ϕₛ + π/2. Idler light that is output at the fourth end of the second coupler has two phases, which are respectively 2ϕ_{p -} ϕₛ + π/2 and 2ϕₚ + 2Δϕₚ⁽¹⁾ - ϕₛ + 3π/2. A crosstalk signal that is output at the fourth end of the second coupler has two phases, which are respectively ϕₚ + π and ϕₚ + Δϕₚ⁽¹⁾ + π.

When the first phase shift Δϕₚ⁽¹⁾ is 2πi, i is a positive integer greater than zero. The first invalid signal is the first crosstalk signal, and the second invalid signal is the second crosstalk signal. Interference cancellation occurs on crosstalk signals that are output at the third end of the second coupler, so that separation between signal light and a crosstalk signal may be implemented at the third end of the second coupler.

When the first phase shift Δϕₚ⁽¹⁾ is π/2 + πi, i is a positive integer greater than zero. The first invalid signal is the first idler light, and the second invalid signal is the second idler light. Interference cancellation occurs on idler light that is output at the third end of the second coupler, so that separation between signal light and idler light may be implemented at the third end of the second coupler.

When the second phase shift Δϕₚ⁽²⁾ is 2πi, i is a positive integer greater than zero. The first end of the second coupler receives the third pump light, and the second end of the second coupler receives the fifth pump light. The third pump light and the fifth pump light cancel each other after interference occurs on the third pump light and the fifth pump light at the third end of the second coupler. Constructive interference occurs on the third pump light and the fifth pump light at the fourth end of the second coupler, and the fourth end of the second coupler outputs pump light generated after the constructive interference.

When the second phase shift Δϕₚ⁽²⁾ is π/2 + πi, i is a positive integer greater than zero. The first end of the second coupler receives the third pump light, and the second end of the second coupler receives the fifth pump light. The third pump light and the fifth pump light cancel each other after interference occurs on the third pump light and the fifth pump light at the fourth end of the second coupler. Constructive interference occurs on the third pump light and the fifth pump light at the third end of the second coupler, and the third end of the second coupler outputs pump light generated after the constructive interference.

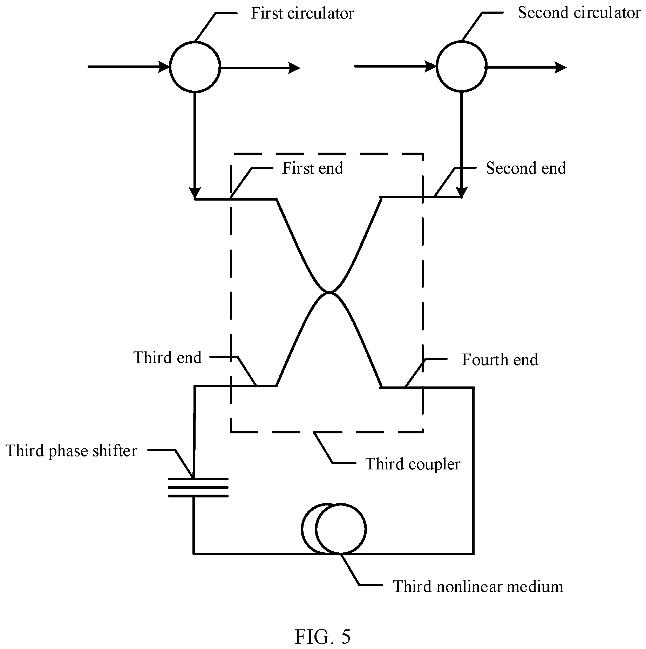

FIG. 5 is a schematic diagram of an embodiment of an optical signal copier according to an embodiment of this application.

Referring to FIG. 5, as shown in FIG. 5, the optical signal copier mentioned in this embodiment of this application includes a first circulator, a second circulator, a third coupler, a third phase shifter, and a third nonlinear medium.

In this embodiment of this application, the circulator is a multi-port component that sequentially transmits an incident wave that enters any port of the circulator to a next port in a direction determined by a static bias magnetic field. The circulator is an irreversible component with a plurality of ends. Optionally, a type of the circulator in this embodiment of this application may be a micro-optic fiber circulator, may be an electronic circulator, or may be another type of circulator. This is not specifically limited herein.

The coupler, the phase shifter, and the nonlinear medium mentioned in this embodiment of this application are similar to the coupler, the phase shifter, and the nonlinear medium mentioned in the embodiment shown in FIG. 2. Details are not described herein.

A first end of the first circulator is connected to a transmitter, a second end of the first circulator is connected to a first end of the third coupler, and a third end of the first circulator is connected to a third attenuator.

A first end of the second circulator is connected to a pump laser, a second end of the second circulator is connected to a second end of the third coupler, and a third end of the second circulator is connected to a fourth attenuator.

In this embodiment of this application, the optical signal copier in an optical parametric amplifier is connected to a signal processing module. Optionally, the signal processing module may include the third attenuator and the fourth attenuator, and the signal processing module may further include another component. This is not specifically limited herein.

A third end of the third coupler is connected to a first end of the third phase shifter, and a fourth end of the third coupler is connected to a first end of the third nonlinear medium.

A second end of the third phase shifter is connected to a second end of the nonlinear medium.

In this embodiment of this application, after the first end of the first circulator receives fourth signal light emitted by the transmitter, the second end of the first circulator outputs the fourth signal light to the first end of the third coupler. After the first end of the second circulator receives sixth pump light emitted by the pump laser, the second end of the second circulator outputs the sixth pump light to the second end of the third coupler.

The first end of the third coupler receives the fourth signal light that is output from the second end of the first circulator, and the second end of the third coupler receives the sixth pump light emitted by the second end of the second circulator. After the third coupler couples the fourth signal light and the sixth pump light based on a proportion, the third end of the third coupler outputs fifth signal light and seventh pump light to the first end of the third phase shifter, and the fourth end of the third coupler outputs sixth signal light and eighth pump light to the first end of the third nonlinear medium.

In this embodiment of this application, the third coupler couples the sixth pump light and the fourth signal light based on a specific proportion. A specific coupling proportion may be 50:50.

In this embodiment of this application, when optical signals are transmitted counterclockwise in the optical signal copier, after the first end of the third phase shifter receives the fifth signal light and the seventh pump light, ninth pump light is generated after the third phase shifter adds a third phase shift to the seventh pump light, and the second end of the third phase shifter outputs the fifth signal light and the ninth pump light to the third nonlinear medium.

After the second end of the third nonlinear medium receives the fifth signal light and the ninth pump light, a three-wave mixing effect or a four-wave mixing effect occurs on the fifth signal light and the ninth pump light in the third nonlinear medium, and a third invalid signal is generated after the three-wave mixing effect or the four-wave mixing effect occurs on the fifth signal light and the ninth pump light. The first end of the third nonlinear medium inputs the fifth signal light, the ninth pump light, and the third invalid signal to the fourth end of the third coupler.

When optical signals are transmitted clockwise in the optical signal copier, after the first end of the third nonlinear medium receives the sixth signal light and the eighth pump light, a three-wave mixing effect or a four-wave mixing effect occurs on the sixth signal light and the eighth pump light in the third nonlinear medium, and a fourth invalid signal is generated after the three-wave mixing effect or the four-wave mixing effect occurs on the sixth signal light and the eighth pump light. The second end of the third nonlinear medium inputs the sixth signal light, the eighth pump light, and the fourth invalid signal to the second end of the third phase shifter.

The second end of the third phase shifter receives the sixth signal light, the eighth pump light, and the fourth invalid signal, and tenth pump light is generated after the third phase shifter adds a fourth phase shift to the eighth pump light. The first end of the third phase shifter inputs the sixth signal light, the tenth pump light, and the fourth invalid signal to the third end of the third coupler.

After the third coupler couples, based on a proportion, optical signals that are received at the third end and the fourth end, the third invalid signal and the fourth invalid signal cancel each other after interference occurs on the third invalid signal and the fourth invalid signal at the first end of the third coupler, constructive interference occurs on the fifth signal light and the sixth signal light, and the first end of the third coupler outputs signal light generated after the constructive interference to the second end of the first circulator. The fifth signal light and the sixth signal light cancel each other after interference occurs on the fifth signal light and the sixth signal light at the second end of the third coupler, and the second end of the third coupler outputs pump light generated after constructive interference and an invalid signal generated after constructive interference.

In this embodiment of this application, the third coupler couples, based on a specific proportion, the optical signals that are received at the third end and the fourth end. A specific coupling proportion may be 1:1.

After the third coupler couples the fourth signal light and the sixth pump light based on the proportion 1:1, the third end of the third coupler outputs the fifth signal light and the seventh pump light to the first end of the third phase shifter. Signal strength of the fifth signal light is 50% of signal strength of the fourth signal light, and phases of the fifth signal light and the fourth signal light are the same. Signal strength of the seventh pump light is 50% of signal strength of the sixth pump light, and a phase difference between the seventh pump light and the sixth pump light is π/2.

The fourth end of the third coupler outputs the sixth signal light and the eighth pump light to the first end of the third nonlinear medium. Signal strength of the sixth signal light is 50% of the signal strength of the fourth signal light, and a phase difference between the sixth signal light and the fourth signal light is π/2. Signal strength of the eighth pump light is 50% of the signal strength of the sixth pump light, and phases of the eighth pump light and the sixth pump light are the same.

After the second end of the first circulator receives the signal light generated after the constructive interference, the third end of the first circulator outputs the signal light generated after the constructive interference to the third attenuator.

When the third phase shift is 2πi, i is a positive integer greater than zero, the third invalid signal is a third crosstalk signal, and the fourth invalid signal is a fourth crosstalk signal.

After the third coupler couples, based on a proportion 1:1, optical signals that are received at the third end and the fourth end, the third crosstalk signal and the fourth crosstalk signal cancel each other after interference occurs on the third crosstalk signal and the fourth crosstalk signal at the first end of the third coupler, constructive interference occurs on the fifth signal light and the sixth signal light, and the first end of the third coupler outputs signal light generated after the constructive interference to the second end of the first circulator. The second end of the third coupler outputs pump light generated after constructive interference and a crosstalk signal generated after constructive interference.

When the third phase shift is π/2 + 2πi, i is a positive integer greater than zero, the third invalid signal is third idler light, and the fourth invalid signal is fourth idler light.

After the third coupler couples, based on a proportion 1:1, optical signals that are received at the third end and the fourth end, the third idler light and the fourth idler light cancel each other after interference occurs on the third idler light and the fourth idler light at the first end of the third coupler, constructive interference occurs on the fifth signal light and the sixth signal light, and the first end of the third coupler outputs signal light generated after the constructive interference to the second end of the first circulator. The second end of the third coupler outputs pump light generated after constructive interference and idler light generated after constructive interference.

In this embodiment of this application, the optical signal copier included in the optical parametric amplifier generates an invalid signal in a process of transmitting signal light and pump light. The optical signal copier may separate the signal light from the invalid signal and then transmit the signal light to the signal processing module. In this way, the signal processing module may directly process the signal light that does not include the invalid signal, the invalid signal does not occupy transmission bandwidth of the optical parametric amplifier, and effective transmission bandwidth of the optical parametric amplifier is relatively large.

The optical signal copier provided in the embodiments of this application is described in detail above. Specific examples are used in this specification to describe principles and implementations of this application. The descriptions in the foregoing embodiments are merely used to help understand the method and core ideas of this application. In addition, a person of ordinary skill in the art may make variations and modifications to this application in terms of the specific implementations and application scopes based on the ideas of this application. Therefore, the content of this specification shall not be construed as a limitation to this application.

## Claims

1. An optical signal copier (copier), comprising a first coupler, a second coupler, a first nonlinear medium, a second nonlinear medium, and a first phase shifter;
a first end of the first coupler is connected to a pump laser, a second end of the first coupler is connected to a transmitter, a third end of the first coupler is connected to a first end of the first nonlinear medium, and a fourth end of the first coupler is connected to a first end of the first phase shifter;
a second end of the first nonlinear medium is connected to a first end of the second coupler;
a second end of the first phase shifter is connected to a first end of the second nonlinear medium;
a second end of the second nonlinear medium is connected to a second end of the second coupler;
the first end of the first coupler receives first pump light emitted by the pump laser, the second end of the first coupler receives first signal light emitted by the transmitter, and after the first coupler couples the first pump light and the first signal light based on a first proportion, the third end of the first coupler outputs second pump light and second signal light to the first nonlinear medium, and the fourth end of the first coupler outputs third pump light and third signal light to the first phase shifter;
after the first nonlinear medium receives the second pump light and the second signal light, a three-wave mixing effect or a four-wave mixing effect occurs on the second pump light and the second signal light in the first nonlinear medium, and a first invalid signal is generated after the three-wave mixing effect or the four-wave mixing effect occurs on the second pump light and the second signal light;
after the first phase shifter receives the third pump light and the third signal light, fourth pump light is generated after the first phase shifter adds a first phase shift to the third pump light;
after the second nonlinear medium receives the fourth pump light and the third signal light, a three-wave mixing effect or a four-wave mixing effect occurs on the fourth pump light and the third signal light in the second nonlinear medium, and a second invalid signal is generated after the three-wave mixing effect or the four-wave mixing effect occurs on the fourth pump light and the third signal light;
the second pump light, the second signal light, and the first invalid signal that are output by the first nonlinear medium are input at the first end of the second coupler, the fourth pump light, the third signal light, and the second invalid signal are input at the second end of the second coupler, and the second coupler couples, based on a second proportion, optical signals that are input at the first end and the second end of the second coupler; and
after the second coupler couples, based on the proportion, the optical signals that are input at the first end and the second end of the second coupler, the first invalid signal and the second invalid signal cancel each other after interference occurs on the first invalid signal and the second invalid signal at a third end of the second coupler, constructive interference occurs on the second signal light and the third signal light at the third end of the second coupler, and the third end of the second coupler outputs signal light generated after the constructive interference.

2. The optical signal copier according to claim 1, wherein the first phase shift is 2πi, i is a positive integer greater than zero, the first invalid signal is a first crosstalk signal, and the second invalid signal is a second crosstalk signal.

3. The optical signal copier according to claim 1, wherein the first phase shift is π/2 + πi, i is a positive integer greater than zero, the first invalid signal is first idler light, and the second invalid signal is second idler light.

4. The optical signal copier according to claim 1, wherein the first proportion is 1:1;
after the first coupler couples the first pump light and the first signal light based on the proportion 1:1, the third end of the first coupler outputs the second pump light and the second signal light to the first nonlinear medium; signal strength of the second pump light is 50% of signal strength of the first pump light, and a phase difference between the second pump light and the first pump light is π/2; signal strength of the second signal light is 50% of signal strength of the first signal light, and phases of the second signal light and the first signal light are the same; and
the fourth end of the first coupler outputs the third pump light and the third signal light to the second nonlinear medium; signal strength of the third pump light is 50% of the signal strength of the first pump light, and phases of the third pump light and the first pump light are the same; signal strength of the third signal light is 50% of the signal strength of the first signal light, and a phase difference between the third signal light and the first signal light is π/2.

5. The optical signal copier according to claims 1 to 4, wherein the optical signal copier further comprises a second phase shifter;
a first end of the second phase shifter is connected to the second nonlinear medium;
a second end of the second phase shifter is connected to the second end of the second coupler; and
after the second phase shifter receives the fourth pump light, the third signal light, and the second invalid signal, fifth pump light is generated after the second phase shifter adds a second phase shift to a phase of the fourth pump light, and the second end of the second phase shifter transmits the fifth pump light to the second end of the second coupler.

6. The optical signal copier according to claim 5, wherein the second phase shift is 2πi, and i is a positive integer greater than zero; and
the first end of the second coupler receives the third pump light, and the second end of the second coupler receives the fifth pump light; the third pump light and the fifth pump light cancel each other after interference occurs on the third pump light and the fifth pump light at the third end of the second coupler; constructive interference occurs on the third pump light and the fifth pump light at a fourth end of the second coupler, and the fourth end of the second coupler outputs pump light generated after the constructive interference.

7. The optical signal copier according to claim 5, wherein the second phase shift is π + 2πi, and i is a positive integer greater than zero; and
the first end of the second coupler receives the third pump light, and the second end of the second coupler receives the fifth pump light; the third pump light and the fifth pump light cancel each other after interference occurs on the third pump light and the fifth pump light at a fourth end of the second coupler; constructive interference occurs on the third pump light and the fifth pump light at the third end of the second coupler, and the third end of the second coupler outputs pump light generated after the constructive interference.

8. An optical signal copier (copier), comprising a first circulator, a second circulator, a third coupler, a third phase shifter, and a third nonlinear medium;
a first end of the first circulator is connected to a transmitter, a second end of the first circulator is connected to a first end of the third coupler, and a third end of the first circulator is connected to a third attenuator;
a first end of the second circulator is connected to a pump laser, a second end of the second circulator is connected to a second end of the third coupler, and a third end of the second circulator is connected to a fourth attenuator;
a third end of the third coupler is connected to a first end of the third phase shifter, and a fourth end of the third coupler is connected to a first end of the third nonlinear medium;
a second end of the third phase shifter is connected to a second end of the nonlinear medium;
after the first end of the first circulator receives fourth signal light emitted by the transmitter, the second end of the first circulator outputs the fourth signal light to the first end of the third coupler;
after the first end of the second circulator receives sixth pump light emitted by the pump laser, the second end of the second circulator outputs the sixth pump light to the second end of the third coupler;
the first end of the third coupler receives the fourth signal light that is output from the second end of the first circulator, and the second end of the third coupler receives the sixth pump light emitted by the second end of the second circulator; after the third coupler couples the fourth signal light and the sixth pump light based on a third proportion, the third end of the third coupler outputs fifth signal light and seventh pump light to the first end of the third phase shifter, and the fourth end of the third coupler outputs sixth signal light and eighth pump light to the first end of the third nonlinear medium;
optical signals are transmitted counterclockwise in the optical signal copier; after the first end of the third phase shifter receives the fifth signal light and the seventh pump light, ninth pump light is generated after the third phase shifter adds a third phase shift to the seventh pump light, and the second end of the third phase shifter outputs the fifth signal light and the ninth pump light to the third nonlinear medium;
after the second end of the third nonlinear medium receives the fifth signal light and the ninth pump light, a three-wave mixing effect or a four-wave mixing effect occurs on the fifth signal light and the ninth pump light in the third nonlinear medium, and a third invalid signal is generated after the three-wave mixing effect or the four-wave mixing effect occurs on the fifth signal light and the ninth pump light; the first end of the third nonlinear medium inputs the fifth signal light, the ninth pump light, and the third invalid signal to the fourth end of the third coupler;
optical signals are transmitted clockwise in the optical signal copier; after the first end of the third nonlinear medium receives the sixth signal light and the eighth pump light, a three-wave mixing effect or a four-wave mixing effect occurs on the sixth signal light and the eighth pump light in the third nonlinear medium, and a fourth invalid signal is generated after the three-wave mixing effect or the four-wave mixing effect occurs on the sixth signal light and the eighth pump light; the second end of the third nonlinear medium inputs the sixth signal light, the eighth pump light, and the fourth invalid signal to the second end of the third phase shifter;
the second end of the third phase shifter receives the sixth signal light, the eighth pump light, and the fourth invalid signal, and tenth pump light is generated after the third phase shifter adds a fourth phase shift to the eighth pump light; the first end of the third phase shifter inputs the sixth signal light, the tenth pump light, and the fourth invalid signal to the third end of the third coupler;
after the third coupler couples, based on a proportion, optical signals that are received at the third end and the fourth end, the third invalid signal and the fourth invalid signal cancel each other after interference occurs on the third invalid signal and the fourth invalid signal at the first end of the third coupler, constructive interference occurs on the fifth signal light and the sixth signal light, and the first end of the third coupler outputs signal light generated after the constructive interference to the second end of the first circulator; the second end of the third coupler outputs pump light generated after constructive interference and an invalid signal generated after constructive interference; and
after the second end of the first circulator receives the signal light generated after the constructive interference, the third end of the first circulator outputs the signal light generated after the constructive interference to the third attenuator.

9. The optical signal copier according to claim 8, wherein the third phase shift is 2πi, i is a positive integer greater than zero, the third invalid signal is a third crosstalk signal, and the fourth invalid signal is a fourth crosstalk signal.

10. The optical signal copier according to claim 8, wherein the third phase shift is π/2 + 2πi, i is a positive integer greater than zero, the third invalid signal is third idler light, and the fourth invalid signal is fourth idler light.

11. The optical signal copier according to claim 8, wherein the third proportion is 1:1;
after the third coupler couples the fourth signal light and the sixth pump light based on the proportion 1:1, the third end of the third coupler outputs the fifth signal light and the seventh pump light to the first end of the third phase shifter; signal strength of the fifth signal light is 50% of signal strength of the fourth signal light, and phases of the fifth signal light and the fourth signal light are the same; signal strength of the seventh pump light is 50% of signal strength of the sixth pump light, and a phase difference between the seventh pump light and the sixth pump light is π/2; and
the fourth end of the third coupler outputs the sixth signal light and the eighth pump light to the first end of the third nonlinear medium; signal strength of the sixth signal light is 50% of the signal strength of the fourth signal light, and a phase difference between the sixth signal light and the fourth signal light is π/2; signal strength of the eighth pump light is 50% of the signal strength of the sixth pump light, and phases of the eighth pump light and the sixth pump light are the same.

12. An optical parametric amplifier, wherein the optical parametric amplifier comprises an optical signal copier, a signal processing apparatus, and a signal amplification apparatus; the signal processing apparatus is configured to process an optical signal that is output by the optical signal copier, and the signal processing apparatus comprises a first attenuator and a second attenuator; the signal amplification apparatus is configured to amplify an optical signal processed by the signal processing apparatus; and the optical signal copier is the optical signal copier according to any one of claims 1 to 7.

13. An optical parametric amplifier, wherein the optical parametric amplifier comprises an optical signal copier, a signal processing apparatus, and a signal amplification apparatus; the signal processing apparatus is configured to process an optical signal that is output by the optical signal copier, and the signal processing apparatus comprises a first attenuator and a second attenuator; the signal amplification apparatus is configured to amplify an optical signal processed by the signal processing apparatus; and the optical signal copier is the optical signal copier according to any one of claims 8 to 11.
